(19)

Europäisches
Patentamt
European
Patent Office
Office européen
des brevets

(11) **EP 2 164 103 A1**

(12) **EUROPEAN PATENT APPLICATION**

(43) Date of publication:
**17.03.2010 Bulletin 2010/11**

(51) Int Cl.:
***H01L 27/146*** (2006.01)          *H04N 1/031* (2006.01)

(21) Application number: **09011373.9**

(22) Date of filing: **04.09.2009**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(30) Priority: **08.09.2008 KR 20080088194**

(71) Applicant: **Sehyun Co., Ltd.
Yeongtong-gu
Suwon-si, Gyeonggi-do (KR)**

(72) Inventors:
• **Choi, Byoung-So
  Seoul (KR)**
• **Choo, Dae-Ho
  Gyeonggi-do (KR)**

(74) Representative: **Scheele, Friedrich et al
Stolmár Scheele & Partner
Patentanwälte
Blumenstrasse 17
80331 München (DE)**

(54) **Image sensor and method of manufacturing the same**

(57)    An image sensor includes a plurality of unit pixels (300) arranged in a matrix shape, each of which is disposed in a region defined by a gate line extending in a first direction and a data line extending in a second direction that is different from the first direction. Each of the unit pixels (300) includes a switching diode (310) and a sensing diode (320). The switching diode (310) has a plus terminal (410) electrically connected to the gate line, and a minus terminal (402) electrically connected to a signal node (N). The sensing diode (320) has a plus terminal (420) electrically connected to the data line (340), and a minus terminal electrically connected to the signal node (N). Therefore, a two-dimensional image may be sensed at once without moving of the sensing module so that scan time (image sensing time) may be reduced.

EP 2 164 103 A1

**Description**

BACKGROUND OF THE INVENTION

FIELD OF THE INVENTION

Exemplary embodiments of the present invention relate to an image sensor and a method of manufacturing the image sensor or, more particularly, to an image sensor capable of reducing sensing time and having a structure for simplifying a manufacturing process thereof and a method of manufacturing the image sensor.

DISCUSSION OF THE BACKGROUND

As office automation progresses, office equipments such as copying machine, scanner, etc. are provided more and more. The copying machine prints pictures, paintings, characters in a paper, and the scanner reads pictures, paintings, characters in a paper to store them as a format of electric file. Recently, theses apparatuses become a digital type. Furthermore, as a personal computer and computer network are provided, a digital multifunctional apparatus, in which a copying machine, a printer, a facsimile, an image scanner, etc. are integrated, has been introduced.

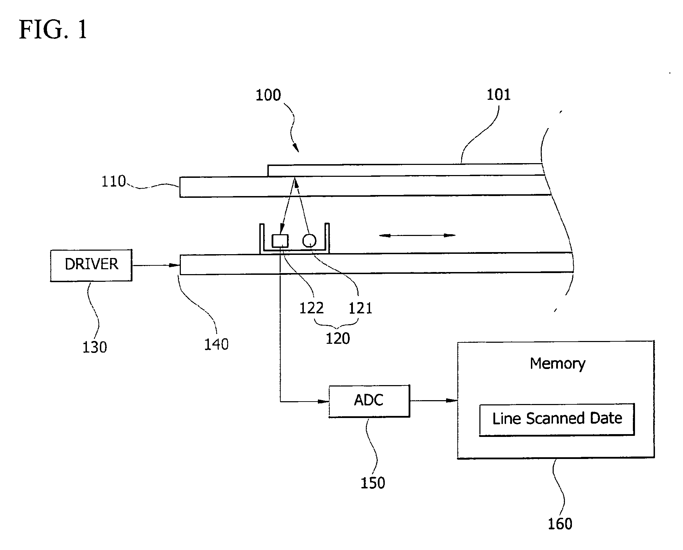

FIG. 1 is a schematic view illustrating a scanner or a copying machine having a conventional image sensor.

Referring to FIG. 1, a conventional apparatus 100 such as a conventional scanner or a conventional copying machine senses an image of a paper 101 on a supporter 110, when a driving module 140 is moved along a direction from one end of the paper 101 to the other end of the paper 101 by a driver 130.

A sensing module 120 of the apparatus 100 includes a light source 121 and an image sensor 122. The light source 121 provides the paper 101 with light and the image sensor 122 receives light reflected by the paper 101 to senses the image of the paper 101.

The images scanned line by line by the sensing module 120 moving the direction from one end to the other end are converted into digital values by an A/D converter 150 to be digitalized image, and the digitalized image is stored in a memory 160.

However, according to the conventional apparatus 100 such as a conventional scanner or a conventional copying machine, the sensing module 120 moves along the direction from one end of the paper 101 to the other end of the paper 101 to scan the image on the paper 101, so that much time is required.

Furthermore, the image sensor of the conventional apparatus 100 employs a thin film transistor (TFT) that requires a lot of manufacturing process to increase manufacturing cost thereof.

SUMMARY OF THE INVENTION

Exemplary embodiments of the present invention provide an image sensor capable of reducing sensing time and having a structure for simplifying a manufacturing process, and a method of manufacturing the image sensor.

Exemplary embodiments of the present invention also provide a method of manufacturing the image sensor.

Additional features of the invention will be set forth in the description which follows, and in part will be apparent from the description, or may be learned by practice of the invention.

An exemplary embodiment of the present invention discloses an image sensor with a plurality of unit pixels arranged in a matrix shape, each of which is disposed in a region defined by a gate line extending in a first direction and a data line extending in a second direction that is different from the first direction. Each of the unit pixels includes a switching diode and a sensing diode. The switching diode has a plus terminal electrically connected to the gate line, and a minus terminal electrically connected to a signal node. The sensing diode has a plus terminal electrically connected to the data line, and a minus terminal electrically connected to the signal node.

For example, the switching diode may include a common electrode, a first N-type semiconductor layer, a first intrinsic semiconductor layer, a first P-type semiconductor layer and a first transparent electrode. The common electrode is formed on a base substrate. The first N-type semiconductor layer is formed on the common electrode. The first intrinsic semiconductor layer is formed on the first N-type semiconductor layer. The first P-type semiconductor layer is formed on the first intrinsic semiconductor layer. The first transparent electrode is formed on the first P-type semiconductor layer.

For example, the sensing diode may include the common electrode, a second N-type semiconductor layer, a second intrinsic semiconductor layer, a second P-type semiconductor layer and a second transparent electrode. The second N-type semiconductor layer is formed on the common electrode such that the second N-type semiconductor layer is spaced apart from the first N-type semiconductor layer of the switching diode. The second intrinsic semiconductor layer is formed on the second N-type semiconductor layer such that the second N-type semiconductor layer is spaced apart from the first intrinsic semiconductor layer of the switching diode. The second P-type semiconductor layer is formed on the second intrinsic semiconductor layer such that the second P-type semiconductor layer is spaced apart from the first P-type semiconductor layer of the switching diode. The second transparent electrode is formed on the P-type semiconductor layer such that the second transparent electrode is spaced apart from the first transparent electrode of the switching diode.

For example, the common electrode may have patterns for improving reflectivity.

For example, the unit pixel may further include a light-blocking layer disposed over the switching diode.

For example, the first intrinsic semiconductor layer of the switching diode and the second intrinsic semiconductor layer of the sensing diode may have a multi-layered structure of an amorphous silicon layer and a micro crystal silicon layer, or amorphous silicon in which nano-clusters of micro-crystalline silicon are randomly distributed.

For example, three neighboring unit pixels may define a pixel part, and a red color filter, a green color filter and a blue color filter may be respectively disposed over three neighboring unit pixels of the pixel part.

For example, the switching diode may include a first intrinsic semiconductor layer, a first P-type semiconductor layer, a first electrode, a first N-type semiconductor layer and a common electrode. The first intrinsic semiconductor layer is formed on a lower surface of a base substrate. The first P-type semiconductor layer is formed on a lower surface of the first intrinsic semiconductor layer. The first electrode is formed on a lower surface of the first P-type semiconductor layer and electrically connected to the gate line. The first N-type semiconductor layer is formed on the lower surface of the first intrinsic semiconductor layer such that the first N-type semiconductor layer is spaced apart from the first P-type semiconductor layer. The common electrode is formed on a lower surface of the first N-type semiconductor layer.

For example, the sensing diode may include a second intrinsic semiconductor layer, a second P-type semiconductor layer, a second electrode, a second N-type semiconductor layer and the common electrode. The second intrinsic semiconductor layer is formed on the lower surface of the base substrate such that the second intrinsic semiconductor layer is spaced apart from the first intrinsic semiconductor layer. The second P-type semiconductor layer is formed on a lower surface of the second intrinsic semiconductor layer. The second electrode is formed on a lower surface of the second P-type semiconductor layer and electrically connected to the data line. The second N-type semiconductor layer is formed on a lower surface of the second intrinsic semiconductor layer such that the second N-type semiconductor layer is spaced apart from the second P-type semiconductor layer and adjacent to the first N-type semiconductor layer. The common electrode formed on a lower surface of the second N-type semiconductor layer such that the common electrode is shared by the switching diode and the sensing diode.

For example, the common electrode and the second electrode may have patterns for improving reflectivity.

For example, the unit pixel may further include a light-blocking layer disposed on an upper surface of the base substrate such that the light-blocking layer is disposed over the switching diode.

For example, the first intrinsic semiconductor layer of the switching diode and the second intrinsic semiconductor layer of the sensing diode may have a multi-layered structure of an amorphous silicon layer and a micro crystal silicon layer, or amorphous silicon in which nano-clusters of micro-crystalline silicon are randomly distributed.

For example, three neighboring unit pixels may define a pixel part, and a red color filter, a green color filter and a blue color filter may be respectively disposed over three neighboring unit pixels of the pixel part.

An exemplary embodiment of the present invention also discloses a method of manufacturing the image sensor. According to the method, a common electrode is formed on a base substrate. An N-type semiconductor film, an intrinsic semiconductor film, a P-type semiconductor film and a transparent and conductive film are sequentially formed on the base substrate having the common electrode formed thereon. The N-type semiconductor film, the intrinsic semiconductor film, the P-type semiconductor film and the transparent and conductive film are patterned to form a switching diode and a sensing diode on the common electrode. Then, an insulation layer is formed on the substrate having the switching diode and the sensing diode formed thereon.

For example, the intrinsic semiconductor film may be formed by forming an amorphous silicon film through a chemical vapor deposition (CVD) process of about 2 MHz to about 13.56 MHz frequency, and forming a micro-crystalline silicon film through a CVD process of about 40 MHz to about 100 MHz frequency.

Forming an amorphous silicon film may be performed under a CVD condition that a ratio of silane gas $(SiH_4)$ to hydrogen gas $(H_2)$ is about 1 : 0.1~1, and a rate of flow of silane gas $(SiH_4)$ is about 10 ~ 100sccm, and a rate of flow of hydrogen gas $(H_2)$ is about 10 ~ 100sccm. Forming a micro-crystalline silicon film is performed under a CVD condition that a ratio of silane gas $(SiH_4)$ to hydrogen gas $(H_2)$ is about 1 : 5~30, and a rate of flow of silane gas $(SiH_4)$ is about 2 ~ 20sccm, and a rate of flow of hydrogen gas $(H_2)$ is about 40 ~ 400sccm.

Alternatively, forming a micro-crystalline silicon layer may be performed under a condition that a ratio of silane gas $(SiH_4)$, hydrogen gas $(H_2)$ and silicon fluoride gas $(SiF_4)$ is about 1 : 5~30 : 1.

An exemplary embodiment of the present invention also discloses another method of manufacturing an image sensor. According to the method, first and second intrinsic semiconductor layers are formed on a lower surface of a base substrate, respectively. First and second P-type semiconductor layers are formed on first and second P-type regions of lower surfaces of the first and second intrinsic semiconductor layers, respectively. A first N-type semiconductor layer is formed on a first N-type region of the lower surface of the first intrinsic semiconductor layer. The first N-type region is spaced apart from the first P-type region. Simultaneously, a second N-type semiconductor layer is formed on a second N-type region of the lower surface of the second intrinsic semiconductor layer. The second N-type region is adjacent to the first N-type region and spaced apart from the second P-type region. Then, a first electrode is formed on a lower surface of the first P-type semiconductor layer, a second electrode is formed on a lower surface of the second P-type semiconductor layer, and a common electrode is formed on lower surface of the first and second N-type semiconductor layers such that the first and second N-type semiconductor layers share the common electrode.

For example, the intrinsic semiconductor film may be formed by forming an amorphous silicon film through a chemical vapor deposition (CVD) process of about 2 MHz to about 13.56 MHz frequency, and forming a micro-crystalline silicon film through a CVD process of about 40 MHz to about 100 MHz frequency.

Forming an amorphous silicon film may be performed under a CVD condition that a ratio of silane gas (SiH4) to hydrogen gas (H2) is about 1 : 0.1~1, and a rate of flow of silane gas (SiH4) is about 10 ~ 100sccm, and a rate of flow of hydrogen gas (H2) is about 10 ~ 100sccm. Forming a micro-crystalline silicon film is performed under a CVD condition that a ratio of silane gas (SiH4) to hydrogen gas (H2) is about 1 : 5~30, and a rate of flow of silane gas (SiH4) is about 2 ~ 20sccm, and a rate of flow of hydrogen gas (H2) is about 40 ~ 400sccm.

Alternatively, forming a micro-crystalline silicon layer may be performed under a condition that a ratio of silane gas (SiH4), hydrogen gas (H2) and silicon fluoride gas (SiF4) is about 1 : 5~30 : 1.

According to the present invention, a two-dimensional image may be sensed at once without moving of the sensing module so that scan time (image sensing time) may be reduced.

Additionally, the switching diode and the sensing diode may be formed simultaneously to reduce the number of manufacturing process. Therefore, inferior goods are reduced to improve productivity.

It is to be understood that both the foregoing general description and the following detailed description are exemplary and explanatory and are intended to provide further explanation of the invention as claimed.

BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1 is a schematic view illustrating a scanner or a copying machine having a conventional image sensor.
FIG. 2 is a schematic view illustrating a first type of a scanner or a copying machine having an image sensor according to an exemplary embodiment of the present invention.
FIG. 3 is a schematic view illustrating a second type of a scanner or a copying machine having an image sensor according to an exemplary embodiment of the present invention.
FIG. 4 is a circuit diagram illustrating a unit pixel of the image sensor in FIG. 2 or FIG. 3 according to an exemplary embodiment of the present invention.
FIG. 5 is a cross-sectional view illustrating an embodiment of the unit pixel in FIG. 4.
FIG. 6 is a cross-sectional view illustrating an intrinsic semiconductor layer in FIG. 5 according to an exemplary embodiment of the present invention.
FIG. 7 is a cross-sectional view illustrating an intrinsic semiconductor layer in FIG. 5 according to another exemplary embodiment of the present invention.
FIG. 8 through FIG. 12 are cross-sectional views illustrating a method of manufacturing the unit pixel in FIG. 5.
FIG. 13 is a graph showing measured data of Raman spectroscopy according to dilution ratios.
FIG. 14 is a cross-sectional view illustrating a unit pixel according to still another exemplary embodiment of the present invention.
FIG. 15 is a cross-sectional view illustrating another embodiment of the unit pixel in FIG. 4.
FIG. 16 is a schematic sectional view illustrating a plasma CVD apparatus capable of being employed for manufacturing the image sensors of the present invention.
FIG. 17 is a perspective view illustrating separated electrode assembly in FIG. 16.
FIG. 18 is a cross-sectional view illustrating a unit pixel according to still another exemplary embodiment of the present invention.

DETAILED DESCRIPTION OF THE ILLUSTRATED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.
It will be understood that when an element or layer is referred to as being "on" or "connected to" another element or layer, it can be directly on or directly connected to the other element or layer, or intervening elements or layers may be present. In contrast, when an element is referred to as being "directly on" or "directly connected to" another element or layer, there are no intervening elements or layers present.

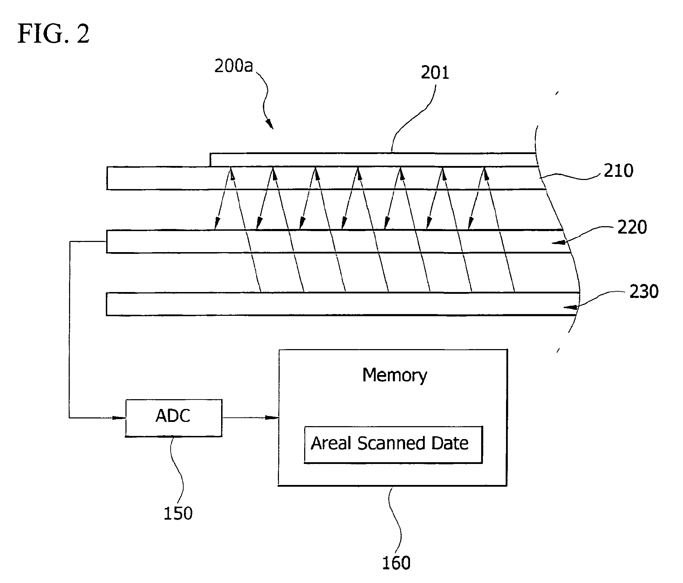

FIG. 2 is a schematic view illustrating a first type of a scanner or a copying machine having an image sensor according to an exemplary embodiment of the present invention.

Referring to FIG. 2, according to an apparatus 200a such as a scanner or a copying machine, according to an exemplary embodiment of the present invention, includes a paper supporter 210, an image sensor 220 and a light source module 230.

The paper supporter 210 is disposed over the image sensor 220 to support a paper 210 on which characters, pictures, etc., are printed.

The light source module 230 is disposed under the image sensor 220 to emit light toward the paper supporter 210. Light passing through the image sensor 220 and arriving at the paper 210 is reflected by the paper 230 to arrive at the image sensor 220. For example, a backlight assembly employed by a liquid crystal display (LED) apparatus may be employed as the light source module 230.

The image sensor 220 includes a plurality of unit pixels (not shown) arranged in a matrix shape to receive the image on the paper 230 by an area unit. The point image of each unit pixel is converted into a digital value by an analog/digital converter (ADC) 150, and the digital value is stored in a memory 160.

According to the present invention, images are read out by area unit not a line unit, so that the image can be read out at once to reduce scan time.

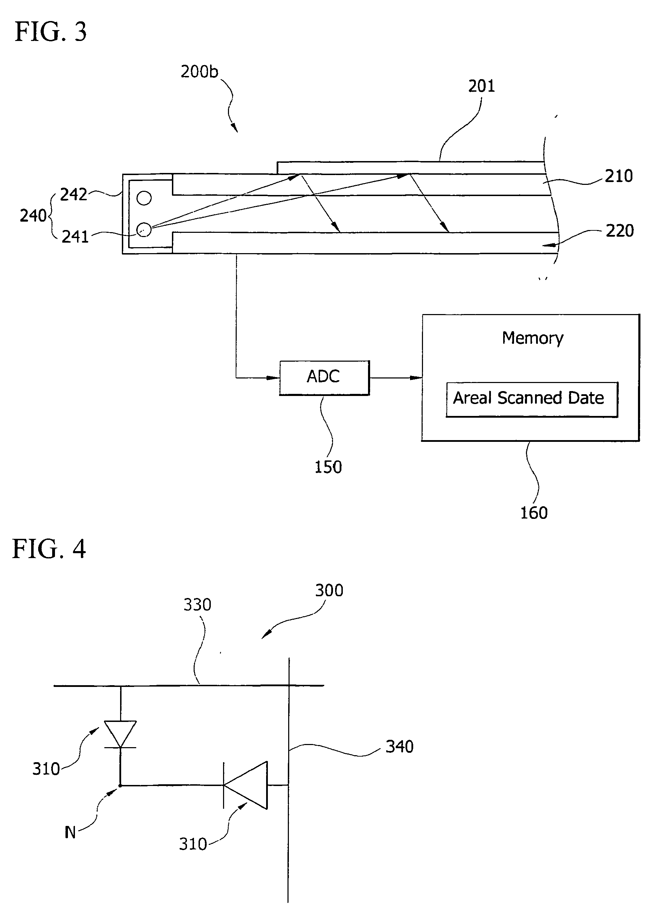

FIG. 3 is a schematic view illustrating a second type of a scanner or a copying machine having an image sensor according to an exemplary embodiment of the present invention. An apparatus 200b such as a scanner or a copying machine in FIG. 3 is substantially the same as the apparatus 200ba in FIG. 2. Thus, same reference numerals will be used for the same elements and any further explanations will be omitted.

Referring to FIG. 3, an apparatus 200b such as a scanner or a copying machine, according to another exemplary embodiment of the present invention, includes a paper supporter 210, an image sensor 220 and a light source module 240.

The light source module 240 in the present embodiment is disposed at a side of the paper supporter 210 and the image sensor 220 to emit light toward a space between the paper supporter 210 and the image sensor 220.

The light source module 240 includes a light source 241 emitting light, and a reflector 242 reflecting the light emitted by the light source 241 to improve light-using efficiency. For example, a cold cathode fluorescent lamp (CCFL), an external electrode fluorescent lamp (EEFL), etc. may be employed as the light source 241.

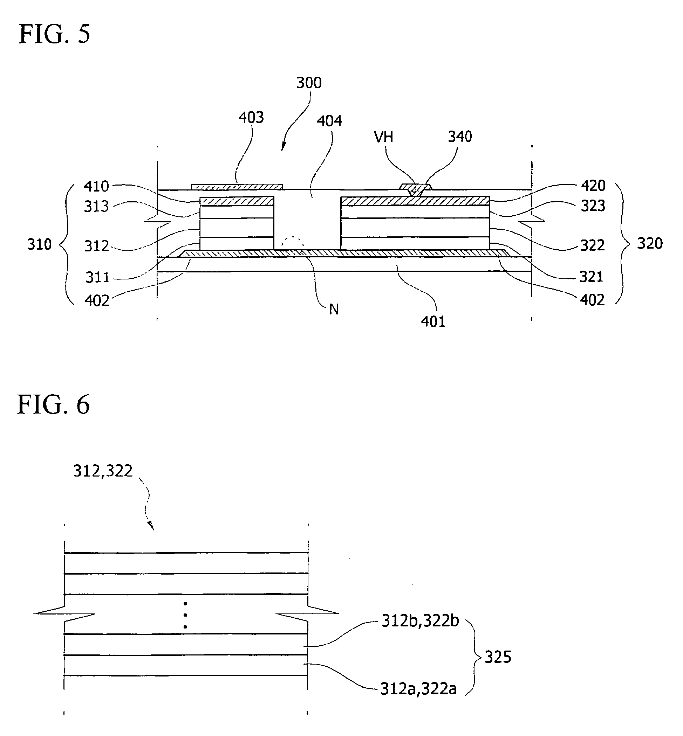

The light emitted by light source module 230 in FIG. 2 should passing through the image sensor 220, so that a marginal space between unit pixels in FIG. 4 and FIG. 5 should be required for the light. However, the apparatus 200b in FIG. 3 does not require this limitation, so that the apparatus 200b may have high resolution.

FIG. 4 is a circuit diagram illustrating a unit pixel of the image sensor in FIG. 2 or FIG. 3 according to an exemplary embodiment of the present invention.

Referring to FIG. 4, a unit pixel 300 of the image sensor 220 in FIG. 2 and FIG. 3 includes a switching diode 310 and a sensing diode 320.

A gate line 330 extends along a first direction and a data line 340 extends along a second direction on a base substrate (not shown) of the image sensor 220. The first and second directions are different from each other. For example, the first and second directions are substantially perpendicular to each other to define unit pixels 300 arranged in a matrix shape.

The unit pixel 300 includes a switching diode 310 and a sensing diode 320.

The switching diode 310 has a plus terminal electrically connected to the gate line 330, and a minus terminal electrically connected to a signal node N. The sensing diode 320 includes a plus terminal electrically connected to the data line 340, and a minus terminal electrically connected to the signal node N.

Hereinafter, an operation of the switching diode 310 and the sensing diode 320 of the unit pixel 300 will be explained.

First, a reset process starts. In the reset process, a reset-voltage is applied to the gate line 330 to turn on the switching diode 310, so that a first voltage is applied to the signal node N to initialize the signal node N. For example, the first voltage is about -5V. In this case, the sensing diode 320 is in a turn-off state.

Then, a standby process starts. In the standby process, a standby-voltage is applied to the gate line 330. For example, the standby-voltage is about 0V. When the standby-voltage is applied to the gate line 330, the switching diode 310 is turned off to fix the signal node N to be the first. In this case, the sensing diode 320 is still in the turn-off state.

Then, a light-sensing process starts. In the light-sensing process, when light reflected by an image arrives at the sensing diode 320, the signal node N is changed to be a second voltage. For example, the second voltage is one in a range of about -5V to about 0V. The second voltage is determined by amount of the light arrives at the sensing diode 320. In this case, the switching diode 310 and the sensing diode 320 are still in the turn-off state.

Then, a data-readout process starts. In the data-readout process, when the reset-voltage is applied to the gate line 330 again, the switching diode 310 is turned on to apply the first voltage to the signal node N and the second voltage of the signal node N is applied to the data line 340.

FIG. 5 is a cross-sectional view illustrating an embodiment of the unit pixel in FIG. 4.

Referring to FIG. 5, the unit pixel is formed on a base substrate 401. The base substrate 401 includes a material that is optically transparent. The base substrate 401 may include, for example, glass or plastic.

The unit pixel 300 formed on the base substrate 401 includes a switching diode 310 and a sensing diode 320. The switching diode 310 and the sensing diode 320 share a common electrode 402 formed on the base substrate 401 to define the signal node N in FIG. 4.

The common electrode 402 may have high reflectivity to improve light-using efficiency to the sensing diode 320. For example, the common electrode 402 includes aluminum (Al), zinc (Zn), molybdenum (Mo), an alloy thereof or oxide thereof.

Now shown in FIG. 5, the common electrode 402 may have patterns for improving reflectivity of the common electrode 402. The patterns of the common electrode 402 may be formed through laser beam. For example, the common electrode 402 may include aluminum molybdenum oxide (AMO) that may be easily processed by laser beam, while having reflectivity that is similar to the reflectivity of silver (Ag).

The switching diode 310 includes the common electrode 402, a first N-type semiconductor layer 311, a first intrinsic semiconductor layer 312, a first P-type semiconductor layer 313 and a first transparent electrode 410. The first N-type semiconductor layer 311 is formed on the common electrode 402. The first intrinsic semiconductor layer 312 is formed on the first N-type semiconductor layer 311. The first P-type semiconductor layer 313 is formed on the first intrinsic semiconductor layer 312. The first transparent electrode 410 is formed on the first P-type semiconductor layer 313.

The sensing diode 320 includes the common electrode 402, a second N-type semiconductor layer 321, a second intrinsic semiconductor layer 322, a second P-type semiconductor layer 323 and a second transparent electrode 420. The second N-type semiconductor layer 321 of the sensing diode 320 is formed on the common electrode 402 such that the second N-type semiconductor layer 321 is spaced apart from the first N-type semiconductor layer 311 of the switching diode 310. The second intrinsic semiconductor layer 322 of the sensing diode 320 is formed on the second N-type semiconductor layer 321 such that the second intrinsic semiconductor layer 322 is spaced apart from the first intrinsic semiconductor layer 312 of the switching diode 310. The second P-type semiconductor layer 323 of the sensing diode 320 is formed on the second intrinsic semiconductor layer 322 such that the second P-type semiconductor layer 323 is spaced apart from the first P-type semiconductor layer 313 of the switching diode 310. The second transparent electrode 420 is formed on the P-type semiconductor layer 323 such that the second transparent electrode 420 is spaced apart from the first transparent electrode 410.

The first and second N-type semiconductor layers 311 and 321 include silicon having N-type dopants such as phosphorus (P), arsenic (As), antimony (Sb), etc., distributed therein. The first and second N-type semiconductor layers 311 and 321 may include at least one of amorphous silicon and micro-crystalline silicon.

In detail, the first and second N-type semiconductor layers 311 and 321 may include amorphous silicon having N-type dopants distributed therein, or micro-crystalline silicon having N-type dopants distributed therein. Furthermore, the first and second N-type semiconductor layers 311 and 321 may have a multi-layered structure of amorphous silicon and microcrystalline silicon, each of which has N-type dopants distributed therein. Electrons generated in the second intrinsic semiconductor layer 322 pass through the second N-type semiconductor layer 321 and arrive at the common electrode 402. Therefore, it is preferable to form the first and second N-type semiconductor layers 311 and 321 with micro-crystalline silicon, since microcrystalline silicon has higher electron mobility than amorphous silicon. The first and second N-type semiconductor layers 311 and 321 has a thickness of about 200□ to about 1000□, and has the resistivity of about 104 $\Omega$-cm to about 105$\Omega$-cm.

The first and second P-type semiconductor layers 313 and 323 are formed on the first and second intrinsic semiconductor layers 312 and 322 such that the first and second P-type semiconductor layers 313 and 323 are disposed over the first and second N-type semiconductor layers 311 and 321, respectively. The first and second P-type semiconductor layers 313 and 323 include silicon having P-type dopants, such as boron (B), potassium (K), etc., distributed therein. The first and second P-type semiconductor layers 313 and 323 may include at least one of amorphous silicon and micro-crystalline silicon.

In detail, the first and second P-type semiconductor layers 313 and 323 may include amorphous silicon having P-type dopants distributed therein, or micro-crystalline silicon having P-type dopants distributed therein. Furthermore, the first and second P-type semiconductor layers 313 and 323 may have a multi-layered structure of amorphous silicon and microcrystalline silicon, each of which has P-type dopants distributed therein.

Light reflected by an image passes through the second P-type semiconductor layer 323 to arrive at the second intrinsic semiconductor layer 322 where photoelectric conversion happens. Therefore, it is preferable to minimize an amount of light absorbed by the second P-type semiconductor layer 323 for maximizing an amount of light arriving at the second intrinsic semiconductor layer 322. In order for that, the first and second P-type semiconductor layers 313 and 323 have different band gap from the first and second intrinsic semiconductor layers 312 and 322. Preferably, the first and second P-type semiconductor layers 313 and 323 have the band gap that is broader than the band gap of the first and second intrinsic semiconductor layers 312 and 322 in order to prevent light from being absorbed by the first and second P-type semiconductor layers 313 and 323. In order to broaden the band gap of the first and second P-type semiconductor layers 313 and 323, the first and second P-type semiconductor layers 313 and 323 may further include carbon (C). For example, the first and second P-type semiconductor layers 313 and 323 have a thickness of about 200□ to about 1000□, which is thinner than the thickness of the first and second intrinsic semiconductor layers 312 and 322.

The first and second transparent electrodes 410 and 420 are formed on the first and second P-type semiconductor layers 313 and 323, respectively. For example, the first and second transparent electrodes 410 and 420 include indium tin oxide (ITO) or indium zinc oxide (IZO). Not shown in FIG. 5, the gate line 330 in FIG. 4, which is electrically connected to the first transparent electrode 410, the first transparent electrode 410 and the second transparent electrode 420 may be formed from a same layer.

An insulation layer 404 is formed on the base substrate 401 having the switching diode 310 and the sensing diode 320 formed thereon to fix and protect the switching diode 310 and the sensing diode 320. The insulation layer 404 includes via-hole VH exposing a portion of the second transparent electrode 420.

A light-blocking layer 403 and the data line 340 are formed on the insulation layer 404. The light-blocking layer 403 is disposed over the switching diode 310 to prevent light reflected by an image from arriving at the switching diode 310. The data line 340 is electrically connected to the second transparent electrode 420 through the via-hole VH, and extends the direction that is perpendicular to the direction of the gate line 330 in FIG. 4.

Now shown in FIG. 5, the unit pixel 300 may have a protection layer formed on the insulation layer 404 having the light-blocking layer 403 and the data line 340 formed thereon in order to protect the light-blocking layer 403 and the data line 340.

FIG. 6 is a cross-sectional view illustrating an intrinsic semiconductor layer in FIG. 5 according to an exemplary embodiment of the present invention. The unit pixel of the present exemplary embodiment is substantially the same as the unit pixel in FIG. 5, except for the first and second intrinsic semiconductor layers. Thus, explanations regarding the same elements will be omitted and only the first and second intrinsic semiconductor layer will be explained.

Referring to FIG. 6, the first and second intrinsic semiconductor layers 312 and 322 have a multi-layered structure of amorphous layer 312a and 322a and micro-crystalline layer 312b and 322b alternately formed from each other. The amorphous layer 312a and 322a includes amorphous silicon, and the micro-crystalline layer 312b and 322b includes micro-crystalline silicon.

In order for that the entire region of the second intrinsic semiconductor layer 322 processes photoelectric effects by light, the total thickness of the amorphous silicon layers 312a and 322a in the second intrinsic semiconductor layer 322 is no less than about 0.4 $\mu$m to have absorption rate of no less than about 95% according to Lambert's law in Expression 1. However, the total thickness of the amorphous silicon layers 312a and 322a is no larger than about 1.0 $\mu$m, for reducing manufacturing time thereof.

Expression 1

$$\log_e I_o/I = \mu d$$

or

$$I = I_o \exp(-\mu d),$$

wherein, $I_o$ is intensity of incident light, I is intensity of transmitted light, $\mu$ is absorption rate, d is a thickness of absorption layer.

The thickness of the first and second intrinsic semiconductor layers 312 and 322 may be adjusted by the ratio of the thickness of the amorphous layer 312a and 322a to the thickness of the micro-crystalline layer 312b and 322b. For example, the thickness of the first and second intrinsic semiconductor layers 312 and 322 is in a range of about 500nm to about 2000nm.

In general, an efficiency of a photoelectric element including silicon is determined by the light absorption rate and efficiency of photoelectric effect. In this view point, the amorphous layer 322a does not have crystal face, so that absorption rate of the amorphous layer 322a is higher than that of the micro-crystalline layer 322b having crystal surface. On the contrary, micro-crystalline layer 322b has an electron mobility that is higher than that of the amorphous layer 322a. Therefore, by alternately forming the amorphous layer 322a having relatively higher light absorption rate and the micro-crystalline layer 322b having relatively higher efficiency of photoelectric effect, the efficiency of the second intrinsic semiconductor layer 322 is optimized.

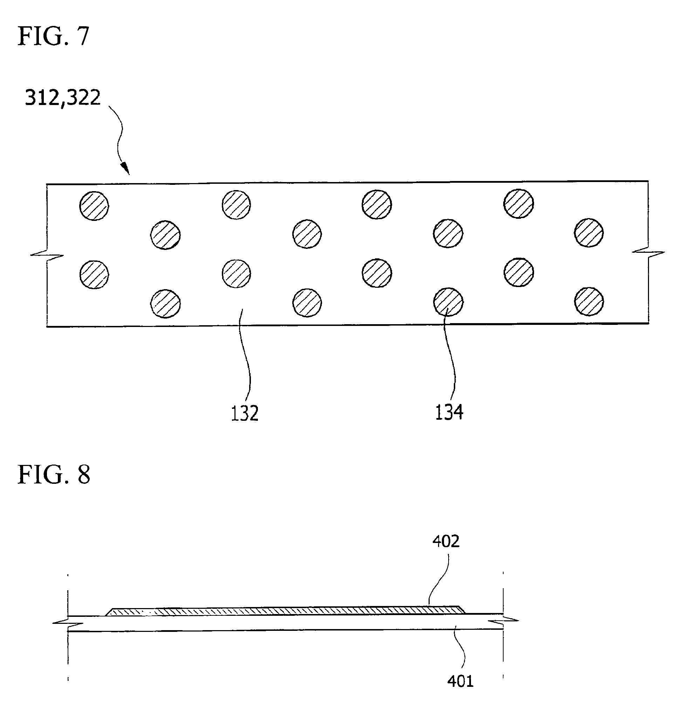

FIG. 7 is a cross-sectional view illustrating an intrinsic semiconductor layer in FIG. 5 according to another exemplary embodiment of the present invention. The unit pixel of the present exemplary embodiment is substantially the same as the unit pixel in FIG. 5, except for the first and second intrinsic semiconductor layers. Thus, explanations regarding the same elements will be omitted and only the first and second intrinsic semiconductor layer will be explained.

Referring to FIG. 7, the first and second intrinsic semiconductor layers 312 and 322 include amorphous silicon 132 and micro-crystalline silicon 134 with a nano-cluster shape, which is randomly distributed in the amorphous silicon 132. The micro-crystalline silicon 134 with a nano-cluster shape is a boundary material between amorphous silicon and single crystal silicon. The micro-crystalline silicon 134 with a nano-cluster shape means micro-crystalline silicon with a cluster shape having a nano scale size. For example, the first and second intrinsic semiconductor layers 312 and 322 may have a thickness of about 300nm to about 500nm, and the size of micro-crystalline silicon 134 with nano-cluster shape may have a size of about 10nm to about 100nm.

As explained above, an efficiency of a photoelectric element including silicon is determined by the light absorption rate and efficiency of photoelectric effect. In this view point, the amorphous silicon 132 does not have crystal face, so that absorption rate of the amorphous silicon 132 is higher than that of the micro-crystalline 134 with a nano-cluster shape having crystal surface. On the contrary, that of the micro-crystalline 134 with a nano-cluster shape has an electron mobility that is higher than that of the amorphous silicon 132. Therefore, when the micro-crystalline silicon 134 with a nano-cluster shape, which has relatively higher electron mobility, is distributed in the amorphous silicon 132, which has relatively higher light absorption rate, the intrinsic semiconductor layer with high light absorption rate and electron mobility is formed to improve photoelectric efficiency. Additionally, the amorphous silicon 132 and the micro-crystalline silicon 134 absorb different light with different wavelength, so that light-using efficiency may be further improved.

FIG. 8 through FIG. 12 are cross-sectional views illustrating a method of manufacturing the unit pixel in FIG. 5.

Referring to FIG. 8, a metal layer (not shown) is formed on the base substrate 401, and the metal layer (not shown) is patterned to form the common electrode 402. For example, the common electrode 402 may be formed through a sputtering process, and a surface of the common electrode 402 may be patterned to improve reflectivity of light. For example, the common electrode 402 include aluminum (Al), zinc (Zn), molybdenum (Mo), alloy thereof, oxide thereof, etc.

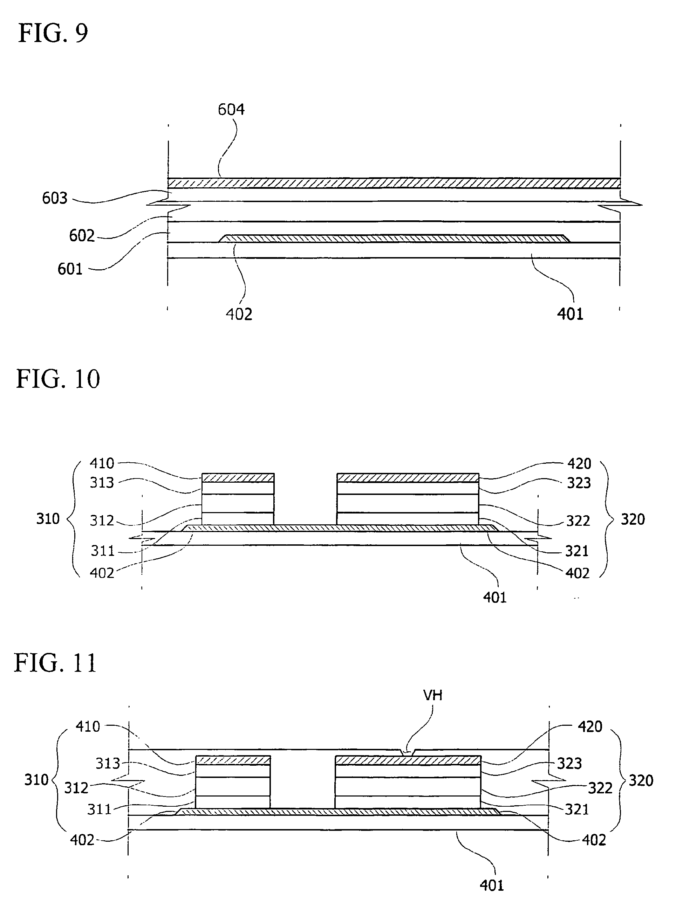

Referring to FIG. 9, an N-type semiconductor film 601, an intrinsic semiconductor film 602, a P-type semiconductor film 603 and a transparent conductive film 604 are sequentially formed on the base substrate 401 having the common electrode 402 formed thereon.

In detail, the N-type semiconductor film 601 having N-type dopants such as phosphorus (P), arsenic (As), antimony (Sb), etc. is formed on the base substrate 401 having the common electrode 402 formed thereon. The N-type semiconductor film 601 may include at least one of an N-type amorphous silicon layer and an N-type micro-crystalline silicon layer. For example, the N-type semiconductor film 601 may be formed through a chemical vapor deposition (CVD) method using about 40 MHz to about 100 MHz frequency to form an N-type micro-crystalline silicon film. Alternatively, the N-type semiconductor film 601 may be formed through a CVD method using about 2 MHz to about 13.56 MHz frequency to form an N-type amorphous silicon film. Alternatively, the N-type semiconductor film 601 may be formed through a chemical vapor deposition (CVD) method alternately using a first frequency of about 2 MHz to about 13.56 MHz and a second frequency of about 40 MHz to about 100 MHz to form a multilayered structure of an N-type amorphous silicon film and an N-type micro-crystalline silicon film.

For example, the N-type semiconductor film 601 in the present embodiment employs an N-type micro-crystalline silicon layer with high electron mobility for improving photoelectric efficiency. For example, the N-type semiconductor film 601 has a thickness of about 200□ to about 1000□.

In order to form the first intrinsic semiconductor layer 312 and 322 in FIG. 6, an intrinsic semiconductor film 602 with a multilayered structure of amorphous film and a micro-crystalline film is formed on the N-type semiconductor film 601.

The amorphous film and the micro-crystalline film may be formed through different CVD process conditions. In forming a silicon thin film through a CVD apparatus, a micro-crystalline silicon layer is easily formed as a frequency and a dilution ratio of hydrogen gas (H2) to silane gas (SiH4) becomes higher.

In detail, the amorphous film may be formed by a CVD condition of about 2 MHz to about 13.56 MHz frequency. In this case, a ratio of silane gas (SiH4) to hydrogen gas (H2) is 1 : 0.1~1, a rate of flow of silane gas (SiH4) is about 10sccm to about 100sccm, and a rate of flow of hydrogen gas (H2) is about 10sccm to about 100sccm.

The micro-crystalline film may be formed by a CVD condition of about 40 MHz to about 100 MHz frequency. In this case, a ratio of silane gas (SiH4) to hydrogen gas (H2) is 1 : 5~30, a rate of flow of silane gas (SiH4) is about 2sccm to about 20sccm, and a rate of flow of hydrogen gas (H2) is about 40sccm to about 400sccm.

Even when the micro-crystalline film is formed according the above condition, an undesirable amorphous film may be firstly formed and then the micro-crystalline film is formed because of the surface condition of a material below. In order to prevent forming the undesirable amorphous film, silicon fluoride gas (SiF4) may be added to silane gas (SiH4) and hydrogen gas (H2). When silicon fluoride gas (SiF4) is added to the process gas of silane gas (SiH4) and hydrogen gas (H2), silicon fluoride gas (SiF4) etches the undesirable amorphous film that is firstly formed in a process of forming micro-crystalline film. For example, a ratio of silane gas (SiH4), hydrogen gas (H2) and silicon fluoride gas (SiF4) is about 1 : 5~30 : 1.

The amorphous film and the micro-crystalline film alternately formed from each other may be sequentially formed by changing process condition such as frequency and gas mixing ratio in one CVD chamber. Alternatively, the amorphous film and the micro-crystalline film may be sequentially formed in a first CVD chamber for forming the amorphous film and in a second CVD chamber for forming the micro-crystalline film, which are connected in line.

Furthermore, the amorphous film and the micro-crystalline film may be formed only through a process of forming micro-crystalline film. In detail, in forming the micro-crystalline film, the amorphous film is firstly and automatically formed an then the micro-crystalline film because of the crystal difference between the micro-crystalline film and the lower layer thereof. Therefore, by adjusting the process condition of the micro-crystalline film, the amorphous film may be formed. For example, the amorphous film and the micro-crystalline film may be simultaneously formed through a CVD condition of the frequency in a range of about 40 MHz to about 100 MHz. In this case the ratio of silane gas (SiH4) to hydrogen gas (H2) is 1 : 5~30.

In order for that the entire region of the intrinsic semiconductor film 602 processes photoelectric effects by light, the total thickness of the amorphous film in the intrinsic semiconductor film 602 is preferably in a range of about 0.4 $\mu$m to about 1.0 $\mu$m.

Then, the P-type semiconductor film 603 having P-type dopants such as boron (B), potassium (K), etc. is formed on the intrinsic semiconductor film 602. The P-type semiconductor film 603 may include at least one of a P-type amorphous silicon layer and a P-type micro-crystalline silicon layer. For example, the P-type semiconductor film 603 may be formed through a chemical vapor deposition (CVD) method using about 40 MHz to about 100 MHz frequency to form a P-type micro-crystalline silicon film. Alternatively, the P-type semiconductor film 603 may be formed through a CVD method using about 2 MHz to about 13.56 MHz frequency to form a P-type amorphous silicon film. Alternatively, the P-type semiconductor film 603 may be formed through a chemical vapor deposition (CVD) method alternately using a first frequency of about 2 MHz to about 13.56 MHz and a second frequency of about 40 MHz to about 100 MHz to form a multilayered structure of a P-type amorphous silicon film and a P-type micro-crystalline silicon film.

In order to prevent light from being absorbed by the P-type semiconductor film 603, it is preferable that the P-type semiconductor film 603 has broader band gap than the intrinsic semiconductor film 602. By adding carbon (C) to reaction gas, the band gap of the P-type semiconductor film 603 may be broaden to enhance light-transmissivity of the P-type semiconductor film 603. For example, the P-type semiconductor film 603 may have a thickness of about 200☐ to about 1000☐ that is thinner than the thickness of the intrinsic semiconductor film 602.

Then, a transparent conductive film 604 including optically transparent and electrically conductive material is formed on the P-type semiconductor film 603. The transparent conductive film 604 may be formed through a sputtering method or a CVD process. For example, the transparent conductive film 604 may include indium tin oxide (ITO) or indium zinc oxide (IZO).

Referring to FIG. 10, the transparent conductive film 604, the P-type semiconductor film 603, the intrinsic semiconductor film 602 and the N-type semiconductor film 601 are patterned to form the switching diode 310 and the sensing diode 320. In patterning the transparent conductive film 604, the P-type semiconductor film 603, the intrinsic semiconductor film 602 and the N-type semiconductor film 601, a laser beam may be used. In detail, the region except for the switching diode 310 and the sensing diode 320 is removed by using the laser beam to form the switching diode 310 and the sensing diode 320.

As described above, when the switching diode 310 and the sensing diode 320 are simultaneously formed through the same process, the manufacturing process may be simplified and the number of inferior goods may be reduced by reducing the number of manufacturing process.

Referring to FIG. 11, the insulation layer (not shown) covering the switching diode 310 and sensing diode 320 is formed on the substrate having the switching diode 310 and sensing diode 320 formed thereon, and the via-hole VH is formed on the insulation layer (not shown) to expose a portion of the second transparent electrode 420 of the sensing diode 320. Therefore, the insulation layer 404 having the via-hole VH is formed.

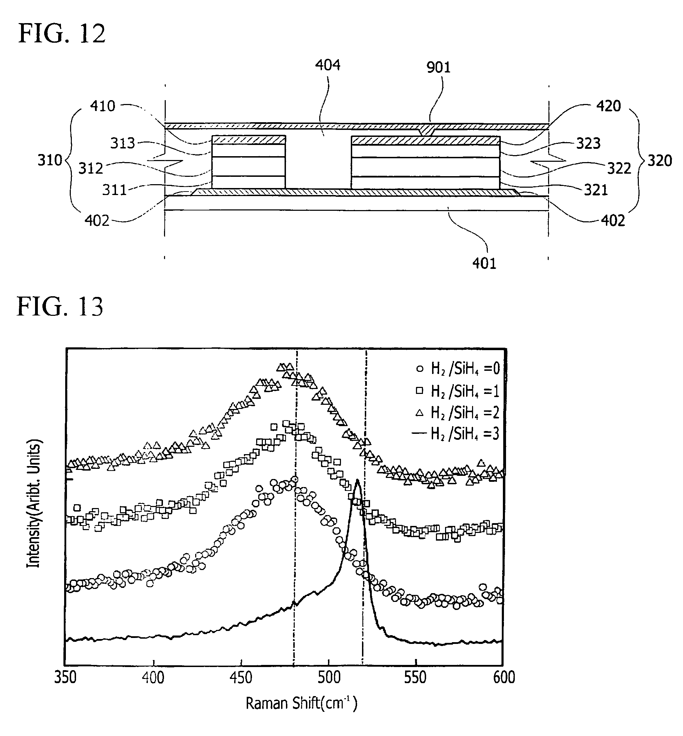

Referring to FIG. 12, a conducting film 901 is formed on the insulation layer 404, and the conducting film 901 is patterned on form the light-blocking layer 403 and the data line 340 in FIG. 5 to form the image.

In the present invention, the shape and arrangement of the data line 340 and the gate line 330 may be variously changed.

As shown in FIG. 7, the intrinsic silicon layer including amorphous silicon 132 and micro-crystalline silicon 134 having nano-cluster shapes randomly distributed in the amorphous silicon 132 may be formed by adjusting dilution ratio of hydrogen gas (H2) to silane gas (SiH4).

FIG. 13 is a graph showing measured data of Raman spectroscopy according to dilution ratios. In FIG. 13, the pressure is about 30mtorr, power is about 300W, temperature of the substrate is about 250☐.

Referring to FIG. 13, Raman shift peak is generated at about 480 cm-1 in amorphous silicon and at about 520 cm-1 in micro-crystalline silicon. Therefore, when dilution ratio hydrogen gas (H2) to silane gas (SiH4) is no less than about 3, microcrystalline phase is generated. Therefore, in order to form the required intrinsic silicon layer 130, the dilution ratio is adjusted in the range of about zero to about two.

The processes of forming other elements except for the intrinsic silicon layer are substantially the same as described above. Thus, any further explanation will be omitted.

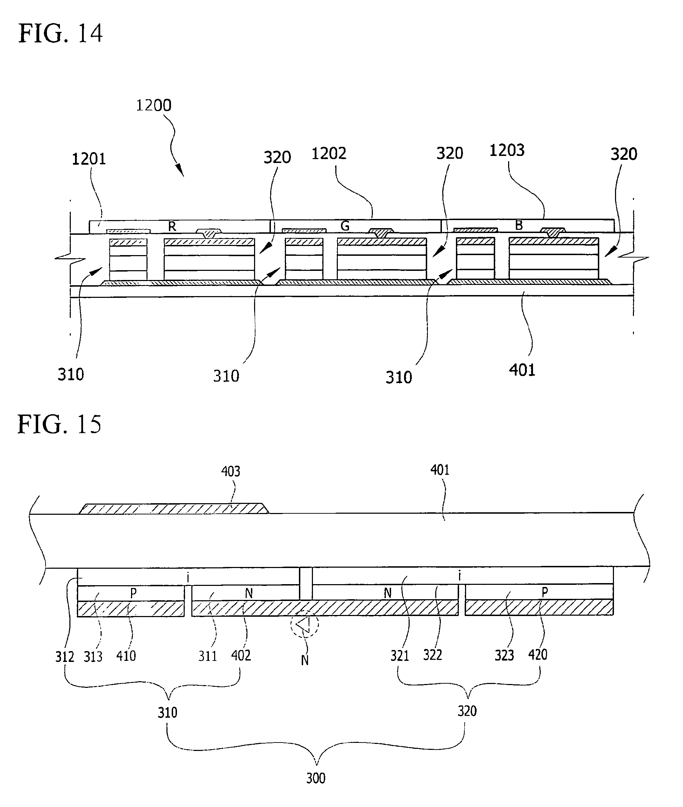

FIG. 14 is a cross-sectional view illustrating a unit pixel according to still another exemplary embodiment of the present invention.

Referring to FIG. 14, in the image sensor according to still another exemplary embodiment of the present invention, three unit pixels 300, for example, each of which corresponds to red, green and blue color, define a pixel part 1200 in order to receive color image. For example, each of the unit pixels 300 may have a rectangular shape, and the pixel part 1200 defined by three unit pixels 300 may have a square shape.

In this case, a red color filter 1201, a green color filter 1202 and a blue color filter 1203 are respectively formed over the three unit pixels 300 defining the pixel part 1200.

Referring again to FIG. 2 or FIG. 3, light reflected by the paper 201 on the paper supporter 210 advanced toward to the pixel part 1200 and passes through the red color filter 1201, the green color filter 1202 and the blue color filter 1203 of the pixel part 1200 to be separated according to color, so that an image may be stored.

According to the present invention, a two-dimensional image may be sensed at once without moving of the sensing module so that scan time (image sensing time) may be reduced.

Additionally, the switching diode and the sensing diode may be formed simultaneously to reduce the number of manufacturing process. Therefore, inferior goods are reduced to improve productivity.

FIG. 15 is a cross-sectional view illustrating another embodiment of the unit pixel in FIG. 4.

Referring to FIG. 15, the unit pixel according to the present exemplary embodiment is formed on a lower surface of a base substrate 401. The base substrate 401 is optically transparent. For example, the base substrate 401 may include glass, plastic, etc.

The unit pixel 300 formed on the lower surface of the base substrate 401 includes a switching diode 310 and a sensing diode 320.

The switching diode 310 includes a first intrinsic semiconductor layer 312, a first P-type semiconductor layer 313, a first N-type semiconductor layer 311, a first electrode 410 and a common electrode 402.

The sensing diode 320 includes a second intrinsic semiconductor layer 322, a second P-type semiconductor layer 323, a second N-type semiconductor layer 321, a second electrode 420 and the common electrode 402. The switching diode 310 and the sensing diode 320 share the common electrode 402 to define the signal node N in FIG. 4.

The first intrinsic semiconductor layer 312 and the second intrinsic semiconductor layer 322 are formed on the lower surface of the base substrate 401 such that the first intrinsic semiconductor layer 312 and the second intrinsic semiconductor layer 322 are spaced apart from each other. The first intrinsic semiconductor layer 312 and the second intrinsic semiconductor layer 322 may have a structure in FIG. 6 or FIG. 7.

The first P-type semiconductor layer 313 and first N-type semiconductor layer 311 are formed on a lower surface of the first intrinsic semiconductor layer 312 such that the first P-type semiconductor layer 313 and first N-type semiconductor layer 311 are spaced apart from each other. The second P-type semiconductor layer 323 and the second N-type semiconductor layer 321 are formed on a lower surface of the second intrinsic semiconductor layer 322 such that the second P-type semiconductor layer 323 and the second N-type semiconductor layer 321 are spaced apart from each other. In this case, the first N-type semiconductor layer 311 and the second N-type semiconductor layer 321 are adjacent to each other. Therefore, in total, the first N-type semiconductor layer 311 and the second N-type semiconductor layer 321 are disposed between the first P-type semiconductor layer 313 and the second P-type semiconductor layer 323.

The first and second first N-type semiconductor layers 311 and 321 include silicon having N-type dopants such as phosphorus (P), arsenic (As), antimony (Sb) etc. The first and second first N-type semiconductor layers 311 and 321 may have at least one of amorphous silicon and micro-crystalline silicon.

In detail, the first and second N-type semiconductor layers 311 and 321 may include amorphous silicon having N-type dopants distributed therein, or micro-crystalline silicon having N-type dopants distributed therein. Furthermore, the first and second N-type semiconductor layers 311 and 321 may have a multi-layered structure of amorphous silicon and microcrystalline silicon, each of which has N-type dopants distributed therein. Electrons generated in the second intrinsic semiconductor layer 322 pass through the second N-type semiconductor layer 321 and arrive at the common electrode 402. Therefore, it is preferable to form the first and second N-type semiconductor layers 311 and 321 with micro-crystalline silicon, since microcrystalline silicon has higher electron mobility than amorphous silicon.

The first and second P-type semiconductor layers 313 and 323 include silicon having P-type dopants, such as boron (B), potassium (K), etc., distributed therein. The first and second P-type semiconductor layers 313 and 323 may include at least one of amorphous silicon and microcrystalline silicon.

In detail, the first and second P-type semiconductor layers 313 and 323 may include amorphous silicon having P-type dopants distributed therein, or micro-crystalline silicon having P-type dopants distributed therein. Furthermore, the first and second P-type semiconductor layers 313 and 323 may have a multi-layered structure of amorphous silicon and microcrystalline silicon, each of which has P-type dopants distributed therein.

The first electrode 410 is formed on a lower surface of the first P-type semiconductor layer 313, and the second electrode 420 is formed on a lower surface of the second P-type semiconductor layer 323. The common electrode 402 is formed on a lower surface of the first N-type semiconductor layer 311 and the second N-type semiconductor layer 321 such that the switching diode 310 and the sensing diode 320 share the common electrode 402.

It is preferable that the second electrode 420 and the common electrode 402 have high conductivity and reflectivity. For example, the second electrode 420 and the common electrode 402 include aluminum (A1), zinc (Zn), molybdenum (Mo), an alloy thereof or oxide thereof. When the second electrode 420 and the common electrode 402 have high conductivity and reflectivity, light passing through the second intrinsic semiconductor layer 322, the second N-type semiconductor layer 321 and the second P-type semiconductor layer 323 may be reflected by the second electrode 420 and the common electrode 402, so that the light may be absorbed by the second intrinsic semiconductor layer 322 to improve light using efficiency.

Now shown in FIG. 15, the common electrode 402 may have patterns for improving reflectivity of the common electrode 402. The patterns of the common electrode 402 may be formed through laser beam. For example, the common electrode 402 may include aluminum molybdenum oxide (AMO) that may be easily processed by laser beam, while having reflectivity that is similar to the reflectivity of silver (Ag).

In FIG. 15, only the structure of the switching diode 310 and the sensing diode 320 is displayed, and the structure of the gate line 330 and the data line 340 in FIG. 4 is omitted. For example, a first insulation layer (not shown) may be formed on a lower surface of the first electrode 410, the second electrode 420 and the common electrode 402, and the gate line 330 electrically connected to the first electrode 410 and extended along a first direction may be formed on a lower surface of the first insulation layer (not shown). Additionally, a second insulation layer (not shown) may be formed on a lower surface of the first insulation layer (not shown) having the gate line 330 formed thereon, and the data line 340 electrically connected to the second electrode 420 and extended along a second direction may be formed on a lower surface of the second insulation layer (not shown).

The first and second intrinsic semiconductor layers 312 and 322 of the unit pixel of the image sensor in FIG. 15 may have a structure in which a plurality of amorphous films and a plurality of micro-crystalline films are alternately stacked as shown in FIG. 6 or include amorphous silicon 132 and micro-crystalline silicon 134 having nano-cluster shapes randomly distributed in the amorphous silicon 132 as shown in FIG. 7.

Hereinafter, referring to FIG. 15 and FIG. 6, a method of manufacturing an image sensor according to an exemplary embodiment of the present invention will be explained.

The first and second intrinsic semiconductor layers 312 and 322 having a structure in which a plurality of amorphous films and a plurality of micro-crystalline films are alternately stacked is formed on a lower surface of the base substrate 401.

The amorphous film and the micro-crystalline film may be formed through different CVD process conditions. In forming a silicon thin film through a CVD apparatus, a micro-crystalline silicon layer is easily formed as a frequency and a dilution ratio of hydrogen gas (H2) to silane gas (SiH4) becomes higher.

In detail, the amorphous film may be formed by a CVD condition of about 2 MHz to about 13.56 MHz frequency. In this case, a ratio of silane gas (SiH4) to hydrogen gas (H2) is 1 : 0.1~1, a rate of flow of silane gas (SiH4) is about 10sccm to about 100sccm, and a rate of flow of hydrogen gas (H2) is about 10sccm to about 100sccm.

The micro-crystalline film may be formed by a CVD condition of about 40 MHz to about 100 MHz frequency. In this case, a ratio of silane gas (SiH4) to hydrogen gas (H2) is 1 : 5~30, a rate of flow of silane gas (SiH4) is about 2sccm to about 20sccm, and a rate of flow of hydrogen gas (H2) is about 40sccm to about 400sccm.

Even when the micro-crystalline film is formed according the above condition, an undesirable amorphous film may be firstly formed and then the micro-crystalline film is formed because of the surface condition of a material below. In order to prevent forming the undesirable amorphous film, silicon fluoride gas (SiF4) may be added to silane gas (SiH4) and hydrogen gas (H2). When silicon fluoride gas (SiF4) is added to the process gas of silane gas (SiH4) and hydrogen gas (H2), silicon fluoride gas (SiF4) etches the undesirable amorphous film that is firstly formed in a process of forming micro-crystalline film. For example, a ratio of silane gas (SiH4), hydrogen gas (H2) and silicon fluoride gas (SiF4) is about 1 : 5~30 : 1.

The amorphous film and the micro-crystalline film alternately formed from each other may be sequentially formed by changing process condition such as frequency and gas mixing ratio in one CVD chamber. Alternatively, the amorphous film and the micro-crystalline film may be sequentially formed in a first CVD chamber for forming the amorphous film and in a second CVD chamber for forming the micro-crystalline film, which are connected in line.

Furthermore, the amorphous film and the micro-crystalline film may be formed only through a process of forming micro-crystalline film. In detail, in forming the micro-crystalline film, the amorphous film is firstly and automatically formed and then the micro-crystalline film because of the crystal difference between the micro-crystalline film and the lower layer thereof. Therefore, by adjusting the process condition of the micro-crystalline film, the amorphous film may be formed. For example, the amorphous film and the micro-crystalline film may be simultaneously formed through a CVD condition of the frequency in a range of about 40 MHz to about 100 MHz. In this case the ratio of silane gas (SiH4) to hydrogen gas (H2) is 1 : 5~30.

Then, with covering a region where the first and second first N-type semiconductor layers 311 and 321 are formed, the first and second first P-type semiconductor layers 313 and 323 having P-type dopants such as boron (B), potassium (K) , etc. are formed on a lower surface of the first and second intrinsic semiconductor layers 312 and 322, respectively.

The first and second first P-type semiconductor layers 313 and 323 may include at least one of a P-type amorphous silicon layer and a P-type micro-crystalline silicon layer. For example, the first and second first P-type semiconductor layers 313 and 323 may be formed through a chemical vapor deposition (CVD) method using about 40 MHz to about 100 MHz frequency to form a P-type micro-crystalline silicon film. Alternatively, the first and second first P-type semiconductor layers 313 and 323 may be formed through a CVD method using about 2 MHz to about 13.56 MHz frequency to form a P-type amorphous silicon film. Alternatively, the first and second first P-type semiconductor layers 313 and 323 may be formed through a chemical vapor deposition (CVD) method alternately using a first frequency of about 2 MHz to about 13.56 MHz and a second frequency of about 40 MHz to about 100 MHz to form a multilayered structure of a P-type amorphous silicon film and a P-type micro-crystalline silicon film.

Then, with covering the first and second P-type silicon layers 313 and 323, the first and second first N-type semiconductor layers 311 and 321 having N-type dopants such as phosphorus (P), arsenic (As), antimony (Sb), etc. may be formed.

The first and second first N-type semiconductor layers 311 and 321 may include at least one of an N-type amorphous silicon layer and an N-type micro-crystalline silicon layer. For example, the first and second first N-type semiconductor layers 311 and 321 may be formed through a chemical vapor deposition (CVD) method using about 40 MHz to about 100 MHz frequency to form an N-type micro-crystalline silicon film. Alternatively, the first and second first N-type semiconductor layers 311 and 321 may be formed through a CVD method using about 2 MHz to about 13.56 MHz frequency to form an N-type amorphous silicon film. Alternatively, the first and second first N-type semiconductor layers 311 and 321 may be formed through a chemical vapor deposition (CVD) method alternately using a first frequency of about 2 MHz to about 13.56 MHz and a second frequency of about 40 MHz to about 100 MHz to form a multilayered structure of an N-type amorphous silicon film and an N-type micro-crystalline silicon film.

Hereinbefore, after the first and second P-type silicon layers 313 and 323 are formed, the first and second first N-type semiconductor layers 311 and 321 are formed. However, after the first and second first N-type semiconductor layers 311 and 321 are formed, the first and second P-type silicon layers 313 and 323 may be formed.

Then, as shown in FIG. 15, the first electrode 410, the second electrode 420 and the common electrode 402 are formed.

Hereinafter, Referring to FIG. 15 and FIG. 7, a method of manufacturing an image sensor according to another exemplary embodiment of the present invention will be explained. The first and second first P-type semiconductor layers 313 and 323 and the first and second first N-type semiconductor layers 311 and 321 may be formed through the method described above, or through the same method of manufacturing the intrinsic semiconductor layer. Thus, the method of manufacturing the first and second intrinsic semiconductor layers 312 and 322 will be focused on.

The first and second intrinsic semiconductor layers 312 and 322 according to the present embodiment includes the amorphous silicon 132 and the micro-crystalline silicon 134 having nano-cluster shapes randomly distributed in the amorphous silicon 132.

The first and second intrinsic semiconductor layers 312 and 322 may be formed through a plasma CVD process. In detail, the intrinsic silicon layer 130 including amorphous silicon 132 and micro-crystalline silicon 134 having nano-cluster shapes randomly distributed in the amorphous silicon 132 may be formed by adjusting dilution ratio of hydrogen gas ($H_2$) to silane gas ($SiH_4$) as described referring to FIG. 13.

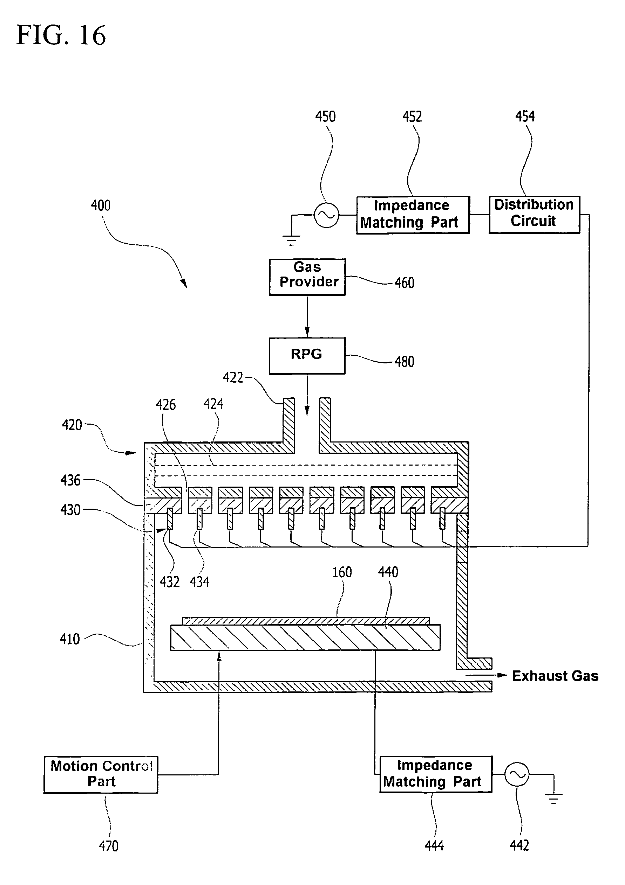

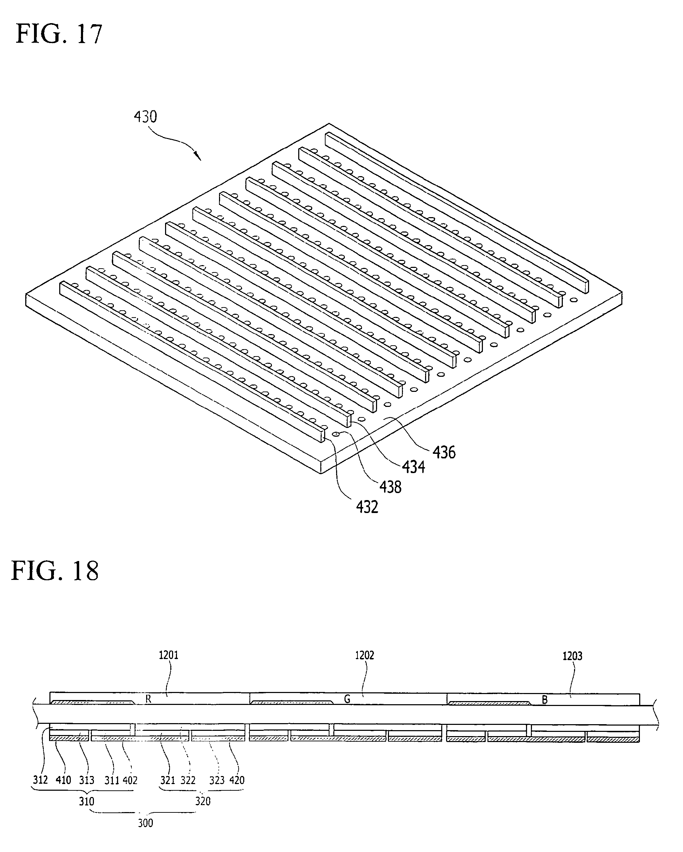

FIG. 16 is a schematic sectional view illustrating a plasma CVD apparatus capable of being employed for manufacturing the image sensors of the present invention, and FIG. 17 is a perspective view illustrating separated electrode assembly in FIG. 16.

Referring to FIG. 16 and FIG. 17, a plasma CVD apparatus 400 includes a chamber body 410 and a separated electrode assembly 430 generating plasma in the chamber body 410.

The separated electrode assembly 430 is disposed such that the separated electrode assembly 430 faces a substrate supporter 440 supporting a substrate 160. The separated electrode assembly 430 includes a plurality of positive voltage electrodes 432 and a plurality of negative voltage electrodes 434 for generating plasma in the chamber body 410. The positive voltage electrodes 432 and the negative voltage electrodes 434 may be alternately disposed with each other with a uniform distance along a line. Alternatively, the positive voltage electrodes 432 and the negative voltage electrodes 434 may be alternatively arranged in a matrix shape, a spiral shape, a concentric circle, etc.

The plasma CVD apparatus 400 may further include a main power supply 450 applying electric power to the positive voltage electrodes 432 and the negative voltage electrodes 434. frequency power (RF power) generated by the main power supply 450 is applied to the positive voltage electrodes 432 and the negative voltage electrodes 434 through an impedance matching part 452 and a distribution circuit 454. The distribution circuit 454 divides RF power generated by the main power supply 450, and distributes the divided RF power to drive the positive voltage electrodes 432 and negative voltage electrodes 434 in parallel. Preferably, the distribution circuit 454 includes a current-balancing circuit for automatically balancing currents applied to the positive voltage electrodes 432 and the negative voltage electrodes 434. The distribution circuit 454 applies positive voltage to the positive voltage electrode 432, and negative voltage to the negative voltage electrode 434. Alternatively, the distribution circuit 454 may apply positive voltage to the positive electrodes 432, and the negative voltage electrodes 434 may be grounded. When the main power supply 450 applies RF power to the positive voltage electrodes 432 and the negative voltage electrodes 434 plasma is generated between the positive voltage electrodes 432 and the negative voltage electrodes 434.

The positive voltage electrodes 432 and the negative voltage electrodes 434 may be formed at an electrode-fixing plate 436. The electrode-fixing plate 436 may include metal, non-metal, or a mixture thereof. When the electrode-fixing plate 436 includes metal, a specific structure for electrically insulating the positive voltage electrodes 432 and the negative voltage electrodes 434, is required. The electrode-fixing plate 436 may includes a plurality of gas injection holes 438. The gas injection holes 438 may have a various shape such as a circular shape, an elliptical shape, a rectangular shape, a triangular shape, a polygonal shape, etc. The gas injection holes 438 may be arranged along a line with a uniform distance between the positive voltage electrode 432 and the negative voltage electrode 434. Alternatively, the gas injection holes 438 may have a slit-shape between the positive voltage electrode 432 and the negative voltage electrode 434.

The plasma CVD apparatus 400 may further include a gas-providing assembly 420 disposed. The gas-providing assembly 420 may include a gas entrance 422 connected to an external gas provider 460, at least one gas distributing plate 424 and a plurality of gas inlets 426. The gas inlets 426 respectively correspond to the gas injection holes 438 of the electrode-fixing plate 436. Therefore, reaction gas provided by the gas provider 460 through gas entrance 422 is uniformly distributed by the at least one gas distributing plate 424, and injected into the chamber body 410 through the gas inlets 426 and the gas injection holes 438.

The substrate supporter 440 may be biased by a bias power supply 442 to improve efficiency of generating plasma. For example, RF power generated by the bias power supply 442 biases the substrate supporter 440 through an impedance matching part 444. Alternatively, the substrate supporter 440 may have doubly biased structure, which receives different RF power from two bias power supplies 442. Alternatively, the substrate supporter 440 may be grounded to maintain zero potential. The substrate supporter 440 may include a heater (not shown) for heating the substrate 310.

The substrate supporter 440 may be moved linearly or rotated by a motion control part 470 to improve process efficiency. Alternatively, the substrate supporter 440 may be fixed to the chamber body 410.

In FIG. 16, the substrate supporter 440 is disposed at a lower portion in the chamber body 410 and the separated electrode assembly 430 is disposed at an upper portion of the chamber body 410, but the substrate supporter 440 may be disposed at the upper portion of the chamber body 410 and the separated electrode assembly 430 may be disposed at the lower portion of the chamber body 410.

According to the plasma CVD apparatus 400, electrodes for generating plasma are formed to have a structure of the plurality of positive voltage electrodes 432 and the plurality of negative voltage electrodes 434 alternately disposed with each other with uniform distance. Therefore, uniform plasma may be generated even when the total area for chemical vapor depositing increases. Furthermore, in parallel driving the positive voltage electrodes 432 and the negative voltage electrodes 434, the currents applied to the positive voltage electrodes 432 and the negative voltage electrodes 434 are automatically balanced, so that uniform plasma may be generated throughout the entire surface of the substrate even through the size of the substrate increases.

The plasma CVD apparatus 400 may further include a remote plasma generator (RPG) 480 for providing the chamber body 410 with plasma. The RPG 480 may be disposed between the gas provider 460 and the chamber body 410. The RPG 480 applies high frequency power to the reaction gas provided by the gas provider 460 to generate plasma. The plasma generated by the RPG 480 may be provided to the chamber body 410 through the gas-providing assembly 420. Additionally, the plasma CVD apparatus 400 may further include a laser generator (not shown) for enhancing density of the plasma.

FIG. 18 is a cross-sectional view illustrating a unit pixel according to still another exemplary embodiment of the present invention.

Referring to FIG. 18, in the image sensor according to still another exemplary embodiment of the present invention, three unit pixels 300, for example, each of which corresponds to red, green and blue color, define a pixel part in order to receive color image.

A red color filter 1201, a green color filter 1202 and a blue color filter 1203 are respectively formed over the three unit pixels 300 defining the pixel part. For example, the red color filter 1201, the green color filter 1202 and the blue color filter 1203 may be formed on upper surface of the base substrate.

Referring again to FIG. 2 or FIG. 3, light reflected by the paper 201 on the paper supporter 210 advanced toward to the pixel part and passes through the red color filter 1201, the green color filter 1202 and the blue color filter 1203 of the pixel part to be separated according to color, so that an image may be stored.

According to the present invention, a two-dimensional image may be sensed at once without moving of the sensing module so that scan time (image sensing time) may be reduced.

Additionally, the switching diode and the sensing diode may be formed simultaneously to reduce the number of manufacturing process. Therefore, inferior goods are reduced to improve productivity.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

**Claims**

1. An image sensor comprising a plurality of unit pixels arranged in a matrix shape, each of which is disposed in a region defined by a gate line extending in a first direction and a data line extending in a second direction that is different from the first direction, each unit pixel comprising:

a switching diode having a plus terminal electrically connected to the gate line, and a minus terminal electrically connected to a signal node; and

a sensing diode having a plus terminal electrically connected to the data line, and a minus terminal electrically connected to the signal node.

2. The image sensor of claim 1, wherein the switching diode comprises:

a common electrode formed on a base substrate;
a first N-type semiconductor layer formed on the common electrode;
a first intrinsic semiconductor layer formed on the first N-type semiconductor layer;
a first P-type semiconductor layer formed on the first intrinsic semiconductor layer; and
a first transparent electrode formed on the first P-type semiconductor layer, and

the sensing diode comprises:
the common electrode;
a second N-type semiconductor layer formed on the common electrode such that the second N-type semiconductor layer is spaced apart from the first N-type semiconductor layer of the switching diode;
a second intrinsic semiconductor layer formed on the second N-type semiconductor layer such that the second N-type semiconductor layer is spaced apart from the first intrinsic semiconductor layer of the switching diode;
a second P-type semiconductor layer formed on the second intrinsic semiconductor layer such that the second P-type semiconductor layer is spaced apart from the first P-type semiconductor layer of the switching diode; and
a second transparent electrode formed on the P-type semiconductor layer such that the second transparent electrode is spaced apart from the first transparent electrode of the switching diode.

3. The image sensor of claim 2, wherein the common electrode has patterns for improving reflectivity.

4. The image sensor of claim 2, further comprising a light-blocking layer disposed over the switching diode.

5. The image sensor of claim 2, wherein the first intrinsic semiconductor layer of the switching diode and the second intrinsic semiconductor layer of the sensing diode have a multilayered structure of an amorphous silicon layer and a micro crystal silicon layer, or amorphous silicon in which nano-clusters of micro-crystalline silicon are randomly distributed.

6. The image sensor of claim 2, wherein three neighboring unit pixels define a pixel part, and a red color filter, a green color filter and a blue color filter are respectively disposed over three neighboring unit pixels of the pixel part.

7. The image sensor of claim 1, wherein the switching diode comprises:

a first intrinsic semiconductor layer formed on a lower surface of a base substrate;
a first P-type semiconductor layer formed on a lower surface of the first intrinsic semiconductor layer;
a first electrode formed on a lower surface of the first P-type semiconductor layer and electrically connected to the gate line;
a first N-type semiconductor layer formed on the lower surface of the first intrinsic semiconductor layer such that the first N-type semiconductor layer is spaced apart from the first P-type semiconductor layer; and
a common electrode formed on a lower surface of the first N-type semiconductor layer; and

the sensing diode comprises:

a second intrinsic semiconductor layer formed on the lower surface of the base substrate such that the second intrinsic semiconductor layer is spaced apart from the first intrinsic semiconductor layer;
a second P-type semiconductor layer formed on a lower surface of the second intrinsic semiconductor layer;

a second electrode formed on a lower surface of the second P-type semiconductor layer and electrically connected to the data line;

a second N-type semiconductor layer formed on a lower surface of the second intrinsic semiconductor layer such that the second N-type semiconductor layer is spaced apart from the second P-type semiconductor layer and adjacent to the first N-type semiconductor layer; and

the common electrode formed on a lower surface of the second N-type semiconductor layer such that the common electrode is shared by the switching diode and the sensing diode.

8. The image sensor of claim 7, wherein the common electrode and the second electrode have patterns for improving reflectivity.

9. The image sensor of claim 7, further comprising a light-blocking layer disposed on an upper surface of the base substrate such that the light-blocking layer is disposed over the switching diode.

10. The image sensor of claim 7, wherein the first intrinsic semiconductor layer of the switching diode and the second intrinsic semiconductor layer of the sensing diode have a multilayered structure of an amorphous silicon layer and a micro crystal silicon layer, or amorphous silicon in which nano-clusters of micro-crystalline silicon are randomly distributed.

11. The image sensor of claim 7, wherein three neighboring unit pixels define a pixel part, and a red color filter, a green color filter and a blue color filter are respectively disposed on an upper surface of the base substrate such that the red color filter, the green color filter and the blue color filter are respectively disposed over three neighboring unit pixels of the pixel part.

12. A method of manufacturing an image sensor, comprising:

forming a common electrode on a base substrate;

sequentially forming an N-type semiconductor film, an intrinsic semiconductor film, a P-type semiconductor film and a transparent and conductive film on the base substrate having the common electrode formed thereon;

patterning the N-type semiconductor film, the intrinsic semiconductor film, the P-type semiconductor film and the transparent and conductive film to form a switching diode and a sensing diode on the common electrode; and

forming an insulation layer on the substrate having the switching diode and the sensing diode formed thereon.

13. The method of claim 12, wherein the intrinsic semiconductor film is formed by:

forming an amorphous silicon film through a chemical vapor deposition (CVD) process of about 2 MHz to about 13.56 MHz frequency; and forming a micro-crystalline silicon film through a CVD process of about 40 MHz to about 100 MHz frequency.

14. The method of claim 13, wherein forming an amorphous silicon film is performed under a CVD condition that

a ratio of silane gas ($SiH_4$) to hydrogen gas ($H_2$) is about 1 : 0.1~1, and

a rate of flow of silane gas ($SiH_4$) is about 10 ~ 100sccm, and a rate of flow of hydrogen gas ($H_2$) is about 10 ~ 100sccm, and

forming a micro-crystalline silicon film is performed under a CVD condition that

a ratio of silane gas ($SiH_4$) to hydrogen gas ($H_2$) is about 1 : 5~30, and

a rate of flow of silane gas ($SiH_4$) is about 2~20sccm, and a rate of flow of hydrogen gas ($H_2$) is about 40 ~ 400sccm.

15. The method of claim 13, wherein forming a micro-crystalline silicon layer is performed under a condition that a ratio of silane gas ($SiH_4$), hydrogen gas ($H_2$) and silicon fluoride gas ($SiF_4$) is about 1 : 5~30 : 1.

16. A method of manufacturing an image sensor, comprising:

forming first and second intrinsic semiconductor layers on a lower surface of a base substrate, respectively;

forming first and second P-type semiconductor layers on first and second P-type regions of lower surfaces of the first and second intrinsic semiconductor layers, respectively;

forming a first N-type semiconductor layer on a first N-type region of the lower surface of the first intrinsic semiconductor layer, the first N-type region being spaced apart from the first P-type region, and a second N-type semiconductor layer on a second N-type region of the lower surface of the second intrinsic semiconductor layer, the second N-type region being adjacent to the first N-type region and spaced apart from the second P-type region; and

forming a first electrode on a lower surface of the first P-type semiconductor layer, a second electrode on a lower surface of the second P-type semiconductor layer, and a common electrode on lower surface of the first and second N-type semiconductor layers such that the first and second N-type semiconductor layers share the common electrode.

17. The method of claim 16, wherein the intrinsic semiconductor film is formed by:
   forming an amorphous silicon film through a chemical vapor deposition (CVD) process of about 2 MHz to about 13.56 MHz frequency; and
   forming a micro-crystalline silicon film through a CVD process of about 40 MHz to about 100 MHz frequency.

18. The method of claim 17, wherein forming an amorphous silicon film is performed under a CVD condition that
   a ratio of si lane gas ($SiH_4$) to hydrogen gas ($H_2$) is about 1 : 0.1~1,
   a rate of flow of silane gas ($SiH_4$) is about 10 ~ 100sccm, and a rate of flow of hydrogen gas ($H_2$) is about 10 ~ 100sccm, and
   forming a micro-crystalline silicon film is performed under a CVD condition that
   a ratio of silane gas ($SiH_4$) to hydrogen gas ($H_2$) is about 1 : 5~30,
   a rate of flow of silane gas ($SiH_4$) is about 2 ~ 20sccm, and a rate of flow of hydrogen gas ($H_2$) is about 40 ~ 400sccm.

19. The method of claim 17, wherein forming a micro-crystalline silicon layer is performed under a condition that a ratio of silane gas ($SiH_4$), hydrogen gas ($H_2$) and silicon fluoride gas ($SiF_4$) is about 1 : 5~30 : 1.

FIG. 1

FIG. 2

## FIG. 3

## FIG. 4

## FIG. 5

## FIG. 6

FIG. 7

312,322

132                              134

FIG. 8

402

401

EP 2 164 103 A1

## FIG. 9

## FIG. 10

## FIG. 11

22

## FIG. 12

## FIG. 13

FIG. 14

FIG. 15

## FIG. 16

FIG. 17

430

436
434
438
432

FIG. 18

1201                    1202                    1203

R                  G                  B

312  410  313  311  402    321  322    323  420

310              320

300

Europäisches
Patentamt

European
Patent Office

Office européen
des brevets

**EUROPEAN SEARCH REPORT**

Application Number

EP 09 01 1373

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | FR 2 593 987 A (THOMSON CSF [FR])<br>7 August 1987 (1987-08-07)<br>* page 5, line 33 - page 6, line 31 *<br>* page 17, line 24 - line 29 *<br>* page 19, line 15 - page 21, line 27 *<br>* figures 1,5,7,8b * | 1-2,6<br>3-5,7-11<br>12-19 | INV.<br>H01L27/146<br><br>ADD.<br>H04N1/031 |
| X<br><br>Y<br>A | EP 0 670 656 A (PHILIPS ELECTRONICS UK LTD [GB]; PHILIPS ELECTRONICS NV [NL])<br>6 September 1995 (1995-09-06)<br>* page 6, line 44 - line 54 *<br>* page 11, line 25 - line 43 *<br>* figures 2,9,10 * | 1,12<br><br>3,13-15<br>2,4-11 | |
| X<br><br>Y<br><br><br>A | US 5 440 149 A (SHIMIZU KOUSAKU [JP] ET AL) 8 August 1995 (1995-08-08)<br>* column 4, line 33 - column 5, line 14 *<br>* column 6, line 8 - line 28 *<br>* column 6, line 49 - line 55 *<br>* claims 1,6; figure 10 * | 16<br><br>4-5,<br>7-11,<br>17-19<br>1-3,6,<br>12-15 | |
| X<br><br>Y<br>A | US 4 746 804 A (KITAMURA KOICHI [US] ET AL) 24 May 1988 (1988-05-24)<br>* column 9, line 15 - line 44 *<br>* figure 6 * | 12<br><br>13-15<br>1-11,<br>16-19 | TECHNICAL FIELDS SEARCHED (IPC)<br><br>H04N<br>H01L |
| Y<br><br>A | US 2008/188033 A1 (CHOI SOO-YOUNG [US] ET AL) 7 August 2008 (2008-08-07)<br>* paragraph [0025] - paragraph [0039] *<br>* paragraph [0045] - paragraph [0047] *<br>* figures 1-3,6 * | 13-15,<br>17-19<br>1-12,16 | |

-/--

The present search report has been drawn up for all claims

| Place of search | Date of completion of the search | Examiner |
|---|---|---|
| Munich | 4 February 2010 | Kostrzewa, Marek |

Europäisches
Patentamt

European
Patent Office

Office européen
des brevets

**EUROPEAN SEARCH REPORT**

Application Number

EP 09 01 1373

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SHAH A V ET AL: "Material and solar cell research in microcrystalline silicon" SOLAR ENERGY MATERIALS AND SOLAR CELLS, ELSEVIER SCIENCE PUBLISHERS, AMSTERDAM, NL, vol. 78, no. 1-4, 1 July 2003 (2003-07-01) , pages 469-491, XP004429028 ISSN: 0927-0248 * paragraphs [0002], [03.1], [03.4], [04.1] * * figures 1-5,8,10 * | 5,10, 13-15, 17-19 | |
| A | EP 0 154 997 A (NIPPON ELECTRIC CO [JP]) 18 September 1985 (1985-09-18) * page 6, line 19 - line 22 * * page 10, line 24 - page 13, line 8 * * figures 3a,3b * | 6,11 | |

TECHNICAL FIELDS
SEARCHED      (IPC)

The present search report has been drawn up for all claims

| Place of search | Date of completion of the search | Examiner |
|---|---|---|
| Munich | 4 February 2010 | Kostrzewa, Marek |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 09 01 1373

This annex lists the patent family members relating to the patent documents cited in the above-mentioned European search report.
The members are as contained in the European Patent Office EDP file on
The European Patent Office is in no way liable for these particulars which are merely given for the purpose of information.

04-02-2010

| Patent document cited in search report | | Publication date | Patent family member(s) | | Publication date |
|---|---|---|---|---|---|
| FR 2593987 | A | 07-08-1987 | DE | 3765272 D1 | 08-11-1990 |
| | | | EP | 0237365 A1 | 16-09-1987 |
| | | | JP | 62202684 A | 07-09-1987 |
| | | | US | 4827145 A | 02-05-1989 |
| EP 0670656 | A | 06-09-1995 | JP | 7264485 A | 13-10-1995 |
| | | | US | 5608205 A | 04-03-1997 |
| US 5440149 | A | 08-08-1995 | JP | 6314779 A | 08-11-1994 |
| US 4746804 | A | 24-05-1988 | NONE | | |
| US 2008188033 | A1 | 07-08-2008 | EP | 2104955 A2 | 30-09-2009 |
| | | | KR | 20080068523 A | 23-07-2008 |
| | | | US | 2008264480 A1 | 30-10-2008 |
| | | | WO | 2008089043 A2 | 24-07-2008 |
| EP 0154997 | A | 18-09-1985 | DE | 3587376 D1 | 08-07-1993 |
| | | | DE | 3587376 T2 | 14-10-1993 |
| | | | US | 4827117 A | 02-05-1989 |
| | | | US | 4758734 A | 19-07-1988 |

EPO FORM P0459

For more details about this annex : see Official Journal of the European Patent Office, No. 12/82